# EUROPEAN PATENT APPLICATION

(11) **EP 4 013 193 A1**
(43) Date of publication of application: **15.06.2022**
(21) Application number: 21207703.6
(22) Date of filing: 11.11.2021
(51) Int. Cl.: H05K 1/14, H05K 3/36

(54) **ELECTRICAL CONNECTOR ASSEMBLY**

(30) Priority: 11.12.2020 US 202017119446
(71) Applicant: Aptiv Technologies Limited, 14004 St. Michael (BB)
(72) Inventor: LOEW, Michael Frederick, El Paso, 79912 (US); ROSALES BACA, Jorge Alberto, Juarez (MX)
(74) Representative: Westphal, Mussgnug & Partner, Patentanwälte mbB

(57) **Abstract**

An electrical assembly (10) is presented herein. The electrical assembly (10) includes a first printed circuit board (12) having a planar first substrate (16) and a first conductive trace disposed thereon, a second printed circuit board (14) distinct from the first printed circuit board (12). The second printed circuit board has a planar second substrate (18) and a second conductive trace disposed thereon. The electrical assembly (10) further includes an electrically conductive device (22) having at least two terminals (24) interconnecting the first conductive trace to the second conductive trace. A method (100) of assembling an electrical distribution center is also presented.

## Description

Motor vehicles are typically equipped with an electrical center that distributes electrical power from the vehicle's electrical power source, e.g., a battery and/or an alternator, to an electrical wiring system of the vehicle that transmit electrical power to the electrical devices in the vehicle. The electrical center typically includes relays to control the electrical power and fuses to protect electrical components of the electrical system from damage caused by short circuits. Electrical centers may alternatively be referred to as electrical distribution centers, fuse blocks, or fuse boxes.

The bussing technology currently used in electrical centers typically use connective traces on a single printed circuit board and/or bus bars formed from stamped sheet metal. Both bussing technologies present a challenge when trying to me the reduced packaging space allowed by future vehicle designs. Stamped metal bus bars typically require an integral tuning fork terminal to interconnect the bus bar with an electrical component, such as a fuse or relay. These tuning fork terminals may increase the vertical (Z) dimension required for packaging the electrical center. Routing the bus bar in the electrical center also presents a challenge because the distribution of the electrical devices in the electrical center could cause a stamped metal design that is too complex to economically manufacture. For the printed circuit board, the cost associated with the unused circuit board material between the electrical components could greatly increase the material cost of the printed circuit board.

Panelization is a manufacturing technique in which smaller printed circuit boards are manufactured in a group and connected into a single array, making it easier and to move through an assembly line and provide more efficient processing. The individual printed circuit boards can easily be depanelized or removed from the array for packaging or installation into a product. Panelization may also involve adding a processing edge around an individual printed circuit board to increase its width to better fit existing handling equipment on the assembly line. For a larger printed circuit board, panelization can cause problems, especially when inserting stamped metal. Panelization optimization becomes harder when working with bigger printed circuit boards.

The subject matter discussed in the background section should not be assumed to be prior art merely because of its mention in the background section. Similarly, a problem mentioned in the background section or associated with the subject matter of the background section should not be assumed to have been previously recognized in the prior art. The subject matter in the background section merely represents different approaches, which in and of themselves may also be inventions.

According to one or more aspects of the present disclosure, an electrical assembly includes a first printed circuit board having a planar first substrate and a first conductive trace disposed thereon, a second printed circuit board distinct from the first printed circuit board, the second printed circuit board having a planar second substrate and a second conductive trace disposed thereon, and an electrically conductive device having at least two terminals interconnecting the first conductive trace to the second conductive trace.

In one or more embodiments of the electrical assembly according to the previous paragraph, the electrically conductive device is a relay.

In one or more embodiments of the electrical assembly according to any one of the previous paragraphs, the electrically conductive device is a fuse.

In one or more embodiments of the electrical assembly according to any one of the previous paragraphs, the electrically conductive device is a jumper formed of sheet metal.

In one or more embodiments of the electrical assembly according to any one of the previous paragraphs, the first substrate is noncoplanar with the second substrate.

In one or more embodiments of the electrical assembly according to any one of the previous paragraphs, the first substrate is nonparallel with the second substrate.

In one or more embodiments of the electrical assembly according to any one of the previous paragraphs, the first printed circuit board includes a first terminal, and the second printed circuit board includes a second terminal. The electrically conductive device is electrically and mechanically interconnected between the first and second terminals via engagement with the at least two terminals.

In one or more embodiments of the electrical assembly according to any one of the previous paragraphs, the first and second terminals are tuning fork terminals.

In one or more embodiments of the electrical assembly according to any one of the previous paragraphs, the electrical assembly is electrical center configured for use in a motor vehicle.

According to one or more aspects of the present disclosure, a method of assembling an electrical distribution center includes the steps of providing a first printed circuit board having a planar first substrate and a first conductive trace disposed thereon, providing a second printed circuit board distinct from the first printed circuit board, the second printed circuit board having a planar second substrate and a second conductive trace disposed thereon, and interconnecting the first conductive trace to the second conductive trace via an electrically conductive device having at least two terminals.

In one or more embodiments of the method according to the previous paragraph, the electrically conductive device is a relay.

In one or more embodiments of the method according to any one of the previous paragraphs, the electrically conductive device is a fuse.

In one or more embodiments of the method according to any one of the previous paragraphs, the method further includes the step of forming the electrically conductive device from sheet metal to provide a jumper.

In one or more embodiments of the method according to any one of the previous paragraphs, the method further includes the step of arranging the first substrate to be noncoplanar with the second substrate.

In one or more embodiments of the method according to any one of the previous paragraphs, the method further includes the step of arranging the first substrate to be nonparallel with the second substrate.

In one or more embodiments of the method according to any one of the previous paragraphs, the first printed circuit board includes a first terminal and the second printed circuit board includes a second terminal and the method further includes the step of electrically and mechanically interconnecting the electrically conductive device between the first and second terminals via engagement of the at least two terminals with the first and second terminals.

In one or more embodiments of the method according to any one of the previous paragraphs, the first and second terminals are tuning fork terminals.

In one or more embodiments of the method according to any one of the previous paragraphs, the electrical distribution center is configured for use in a motor vehicle.

In one or more embodiments of the method according to any one of the previous paragraphs, the method further includes the step of disposing the electrical distribution center in a motor vehicle.

According to one or more aspects of the present disclosure, an electrical assembly includes a first printed circuit board having a planar first substrate and a first conductive trace disposed thereon, a second printed circuit board distinct from the first printed circuit board, the second printed circuit board having a planar second substrate and a second conductive trace disposed thereon, and means for interconnecting the first conductive trace to the second conductive trace via an electrically conductive device having at least two terminals.
Fig. 1 is a perspective view of an electrical assembly according to some embodiments;
Fig. 2 is top view of the electrical assembly of Fig. 1 according to some embodiments;
Fig. 3 is a side view of the electrical assembly of Fig. 1 according to some embodiments;
Fig. 4 is a cross-section view of the electrical assembly of Fig. 1 according to some embodiments; and

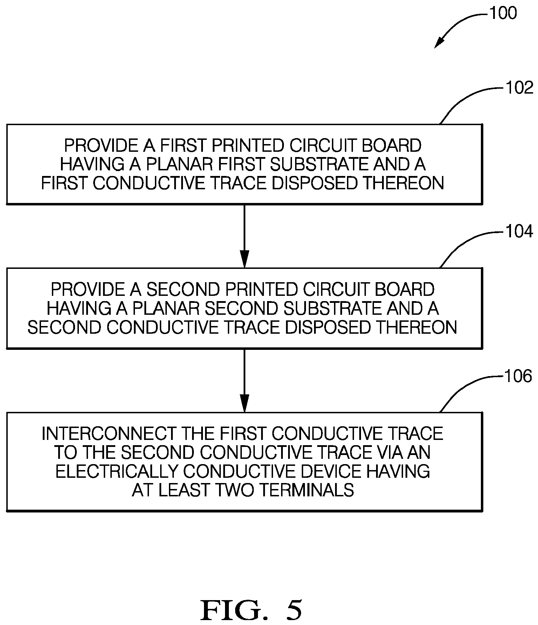

Fig. 5 is a flowchart of a method of assembling an electrical distribution center according to some embodiments.

The problem of having complex stamped metal bus bar designs or having unnecessary area on a printed circuit board is solved through the implementation of a modular electrical center design. Depending on the design layout various ways to achieve these are possible. Separating individual circuits into a separate printed circuit boards on which the used area of the printed circuit board is maximized and the unused area of the printed circuit board is minimized and interconnecting these separate printed circuit real state area through electrical devices, e.g. fuses or relays or small stamped metal jumpers. This solution also helps with the vertical direction constraints on the electrical center packaging, as the various printed circuit boards can be arranged at different positions on the vertical axis, therefore allowing the electrical center designer to optimize the vertical position of a given particular group of devices in the electrical center.

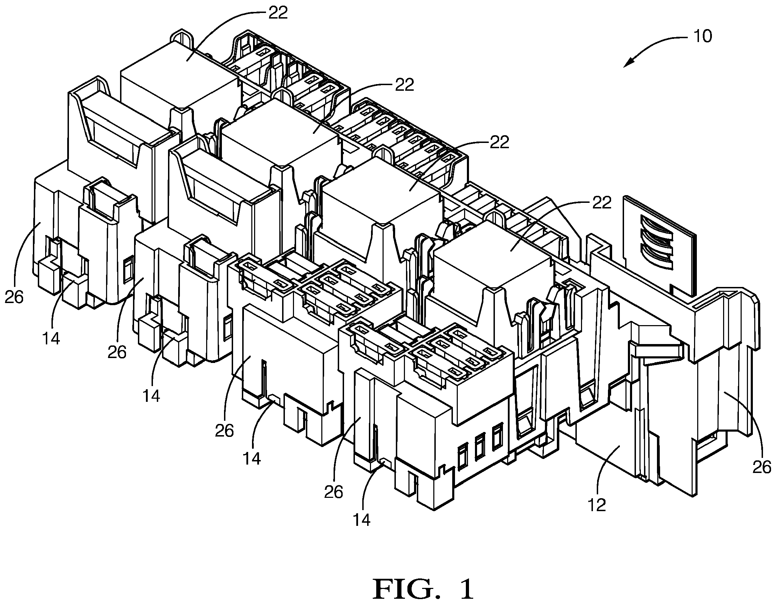

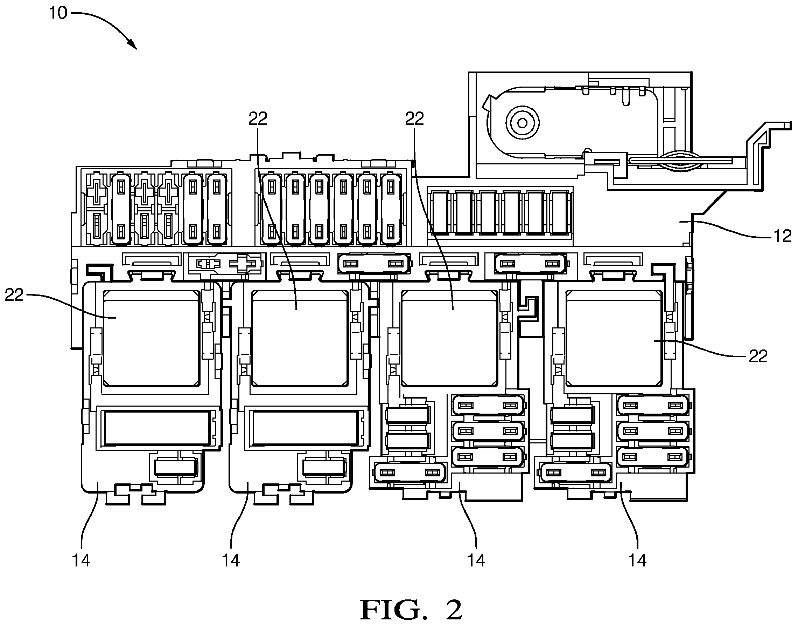

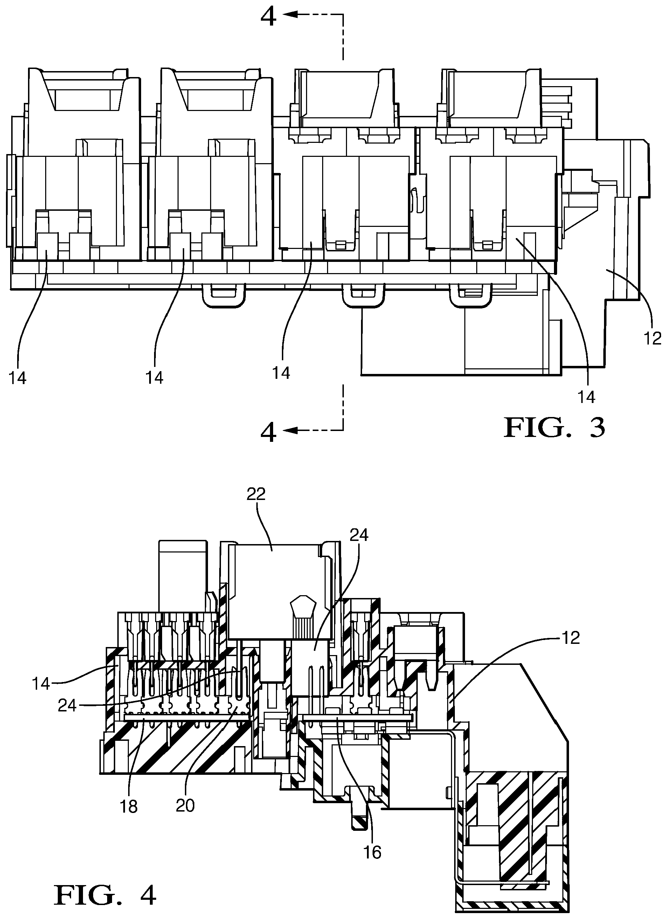

This application is directed to an electrical assembly which in the illustrated example in Figs. 1-4 is an electrical center designed for use in a motor vehicle. As shown, the electrical assembly, hereinafter referred to as the assembly 10 includes a first printed circuit board 12 and a separate second printed circuit board 14. Each of the first and second printed circuit boards 12, 14 includes a circuit board substrate 16, 18 and at least one conductive trace disposed on a surface of the circuit board substrate 16, 18 or within the circuit board substrate 16, 18. The circuit board substrates 16, 18 may be formed of epoxy or polyimide resins. The resin may be reinforced with a woven glass cloth or other matrix such as chopped fibers. Circuit board substrates formed of such materials are typically referred to as FR-4 or G-10 type circuit boards. The circuit board substrates 16, 18 may alternatively be constructed of ceramic or rigid polymer materials. This listing of acceptable substrate materials is not exhaustive and other materials may also be used successfully. A layer of conductive material, such as a copper-based material is electroplated on at least one major surface of each circuit board substrate 16, 18. The layer of conductive material is then formed to create the conductive traces, typically by using a chemical etching process.

The first and second printed circuit boards 12, 14 each include a female tuning fork terminal 20 attached to the respective conductive traces. The first and second printed circuit boards 12, 14 are electrically and mechanically interconnected by an electrically conductive device 22 having two male blade terminals 24 received within the female tuning fork terminals 20, thereby interconnecting the first conductive trace on the first printed circuit board 12 to the second conductive trace on the second circuit board 14. In the illustrated example, the electrically conductive device 22 is a relay module, however in alternative embodiments, the electrically conductive device 22 may be a fuse module, diode module, or a jumper formed of sheet metal. The printed circuit board terminals 20 and electrical device terminals 24 are not limited to the terminal types illustrated but may be any combination of compatible terminal types.

The first and second printed circuit boards 12, 14 and the electrically conductive device may be housed in electrically insulative housings 26 (see Fig. 1) that are contained in an electrically insulative case (not shown).

The second printed circuit board 14 may be arranged such that its major surface is not coplanar with the major surface of the first circuit board 12. In addition, the second printed circuit board 14 may be arranged such that its major surface is not parallel with, or may be perpendicular to, the major surface of the first circuit board 12. Arranging the second circuit board 14 to be nonplanar and/or nonparallel to the first circuit board 12 may provide a reduction in the overall packaging size of the assembly 10. In addition, the inventors have been able to realize a reduction in printed circuit board area of at least 45% which provides material cost savings for the material required to manufacture the first and second circuit boards 12, 14.

In the nonlimiting illustrated example, the first printed circuit board 12 is a motherboard 12, and the second printed circuit board 14 is one of the four daughterboards 14. In the illustrated example, each of the four daughterboards 14 are electrically and mechanically interconnected to the motherboard 12 by a relay module 22. The motherboard 12 may be connected to the vehicle electrical power supply while the daughterboards 14 are connected to various circuits in the vehicle to provide electrical protection and control for those circuits

A method 100 for of assembling an electrical distribution center, such as the assembly 10 described above is also presented herein. The method 100 includes the following steps:

STEP 102, PROVIDE A FIRST PRINTED CIRCUIT BOARD HAVING A PLANAR FIRST SUBSTRATE AND A FIRST CONDUCTIVE TRACE DISPOSED THEREON, includes providing a first printed circuit board 12 having a planar first substrate 16 and a first conductive trace disposed thereon;

STEP 104, PROVIDE A SECOND PRINTED CIRCUIT BOARD HAVING A PLANAR SECOND SUBSTRATE AND A SECOND CONDUCTIVE TRACE DISPOSED THEREON, includes providing a second printed circuit board 14 having a planar second substrate 18 and a second conductive trace disposed thereon; and

STEP 106, INTERCONNECT THE FIRST CONDUCTIVE TRACE TO THE SECOND CONDUCTIVE TRACE VIA AN ELECTRICALLY CONDUCTIVE DEVICE HAVING AT LEAST TWO TERMINALS, includes interconnecting the first conductive trace to the second conductive trace via an electrically conductive device 22 having at least two terminals 24. The electrically conductive device 22 may be a relay, a fuse, or a jumper in which case the method 100 may further include an optional step of forming the electrically conductive device 22 from sheet metal to provide a jumper.

Prior to STEP 106, the method 100 may include the optional steps of arranging the first substrate 16 to be noncoplanar with the second substrate 18 and/or arranging the first substrate 16 to be nonparallel with the second substrate 18. The first printed circuit board 12 may include a first terminal 20 and the second printed circuit board 14 may include a second terminal 20. In this case, STEP 106 further includes electrically and mechanically interconnecting the electrically conductive device 22 between the first and second terminals 20 via engagement of two of the terminals 24 on the electrically conductive device 22 with the first and second terminals 20.

Following STEP 106, the method 100 may further include the step of disposing the electrical distribution center in a motor vehicle.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention is not limited to the disclosed embodiment(s), but that the invention will include all embodiments falling within the scope of the appended claims.

## Claims

1. An electrical assembly (10), comprising:
a first printed circuit board (12) having a planar first substrate (16) and a first conductive trace disposed thereon;
a second printed circuit board (14) distinct from the first printed circuit board (12), the second printed circuit board (14) having a planar second substrate (18) and a second conductive trace disposed thereon; and
an electrically conductive device (22) having at least two terminals (24) interconnecting the first conductive trace to the second conductive trace.

2. The electrical assembly (10) according to claim 1, wherein the electrically conductive device (22) is a relay.

3. The electrical assembly (10) according to claim 1 or 2, wherein the electrically conductive device (22) is a fuse.

4. The electrical assembly (10) according to any one of the preceding claims, wherein the electrically conductive device (22) is a jumper formed of sheet metal.

5. The electrical assembly (10) according to any one of the preceding claims, wherein the first substrate is noncoplanar with the second substrate.

6. The electrical assembly according to any one of the preceding claims, wherein the first substrate (16) is nonparallel with the second substrate (18).

7. The electrical assembly (10) according to any one of the preceding claims, wherein the first printed circuit board (12) includes a first terminal, and the second printed circuit board (14) includes a second terminal and wherein the electrically conductive device (22) is electrically and mechanically interconnected between the first and second terminals via engagement with the at least two terminals (24).

8. The electrical assembly (10) according to claim 7, wherein the first and second terminals are tuning fork terminals.

9. The electrical assembly (10) according to claim 7 or 8, wherein the electrical assembly (10) is electrical center configured for use in a motor vehicle.

10. A method (100) of assembling an electrical distribution center, comprising:
providing (102) a first printed circuit board (12) having a planar first substrate (16) and a first conductive trace disposed thereon;
providing (104) a second printed circuit board (14) distinct from the first printed circuit board (12), the second printed circuit board (14) having a planar second substrate (18) and a second conductive trace disposed thereon; and
interconnecting (106) the first conductive trace to the second conductive trace via an electrically conductive device (22) having at least two terminals (24).

11. The method (100) according to claim 10, wherein the electrically conductive device (22) is a relay or a fuse.

12. The method (100) according to claim 10 or 11, further comprising forming the electrically conductive device (22) from sheet metal to provide a jumper.

13. The method (100) according to any one of the claims 10 to 12, further comprising arranging the first substrate (16) to be noncoplanar and/or nonparallel with the second substrate (18).

14. The method (100) according to any one of the claims 10 to 12, wherein the first printed circuit board (12) includes a first terminal, and the second printed circuit board (14) includes a second terminal and further comprising electrically and mechanically interconnecting the electrically conductive device between the first and second terminals via engagement of the at least two terminals (24) with the first and second terminals.

15. The method (100) according to claim 14, wherein the first and second terminals are tuning fork terminals.
